# FASCICULE DE BREVET EUROPEEN

(11) **EP 4 128 329 B1**
(45) Date de publication et mention de la délivrance du brevet: **03.04.2024**
(21) Numéro de dépôt: 21704868.5
(22) Date de dépôt: 12.01.2021
(51) Int. Cl.: H01L 21/762, H01L 21/02

(54) **PROCEDE DE FABRICATION D'UNE STRUCTURE COMPOSITE COMPRENANT UNE COUCHE MINCE EN SIC MONOCRISTALLIN SUR UN SUBSTRAT SUPPORT EN SIC**
VERFAHREN ZUR HERSTELLUNG EINER VERBUNDSTRUKTUR MIT EINER DÜNNEN SCHICHT AUS MONOKRISTALLINEM SIC AUF EINEM TRÄGERSUBSTRAT AUS SIC
METHOD FOR MANUFACTURING A COMPOSITE STRUCTURE COMPRISING A THIN LAYER MADE OF MONOCRYSTALLINE SIC ON A CARRIER SUBSTRATE MADE OF SIC

(30) Priorité: 27.03.2020 FR 2003026
(43) Date de publication de la demande: 08.02.2023
(73) Titulaire: SOITEC, 38190 Bernin (FR)
(72) Inventeur: BIARD, Hugo, 38100 GRENOBLE (FR); RADU, Ionut, 38920 CROLLES (FR); LANDRU, Didier, 38190 LE CHAMP-PRES-FROGES (FR)
(74) Mandataire: IP Trust
(86) Numéro de dépôt international: PCT/FR2021/050047
(87) Numéro de publication internationale: WO 2021/191512

(56) Documents cités:
- DE-A1-102014 103 518
- FR-A1- 2 857 982
- FR-B1- 2 857 982
- JP-A- 2007 273 524
- US-A1- 2018 251 910

## Description

### DOMAINE DE L'INVENTION

La présente invention concerne le domaine des matériaux semiconducteurs pour composants microélectroniques. Elle concerne en particulier un procédé de fabrication d'une structure composite comprenant une couche mince en carbure de silicium monocristallin sur un substrat support en carbure de silicium.

### ARRIERE PLAN TECHNOLOGIQUE DE L'INVENTION

L'intérêt pour le carbure de silicium (SiC) a considérablement augmenté au cours des dernières années, car ce matériau semiconducteur peut accroître la capacité de traitement de l'énergie. Le SiC est de plus en plus largement utilisé pour la fabrication de dispositifs de puissance innovants, pour répondre aux besoins de domaines montants de l'électronique, comme notamment les véhicules électriques.

Les dispositifs de puissance et les systèmes intégrés d'alimentation basés sur du carbure de silicium monocristallin peuvent gérer une densité de puissance beaucoup plus élevée par rapport à leurs homologues traditionnels en silicium, et ce avec des dimensions de zone active inférieures. Pour limiter encore les dimensions des dispositifs de puissance sur SiC, il est avantageux de fabriquer des composants verticaux plutôt que latéraux. Pour cela, une conduction électrique verticale, entre une électrode disposée en face avant de la structure SiC et une électrode disposée en face arrière, doit être autorisée par ladite structure.

Les substrats en SiC monocristallin destinés à l'industrie microélectronique restent néanmoins chers et difficiles à approvisionner en grande taille. Il est donc avantageux de recourir à des solutions de transfert de couches minces, pour élaborer des structures composites comprenant typiquement une couche mince en SiC monocristallin sur un substrat support plus bas coût. Une solution de transfert de couche mince bien connu est le procédé Smart Cut^{™}, basé sur une implantation d'ions légers et sur un assemblage par collage direct. Un tel procédé permet par exemple de fabriquer une structure composite comprenant une couche mince en SiC monocristallin (c-SiC), prélevée d'un substrat donneur en c-SiC, en contact direct avec un substrat support en SiC poly-cristallin (p-SiC), et autorisant une conduction électrique verticale. Il reste néanmoins difficile de réaliser un collage direct par adhésion moléculaire de bonne qualité entre deux substrats c-SiC et p-SiC, car la gestion de la rugosité et de l'état de surface desdits substrats est complexe.

Différentes méthodes dérivées de ce procédé sont également connues de l'état de la technique. Par exemple, F.Mu et al (ECS Transactions, 86 (5) 3-21, 2018) mettent en oeuvre un collage direct, après activation des surfaces à assembler par bombardement d'argon (SAB pour « Surface Activation bonding ») : un tel traitement préalable au collage génère une très forte densité de liaisons pendantes, lesquelles favorisent la formation de liaisons covalentes à l'interface d'assemblage, et donc une forte énergie de collage. Cette méthode présente néanmoins l'inconvénient de générer une couche amorphe, à la surface du substrat donneur en SiC monocristallin, qui impacte défavorablement la conduction électrique verticale entre la couche mince en c-SiC et le substrat support en p-SiC.

Des solutions ont été proposées pour résoudre ce problème, en particulier dans le document EP3168862, mettant en oeuvre une implantation d'espèces dopantes dans ladite couche amorphe, pour restaurer ses propriétés électriques. L'inconvénient principal de cette approche est sa complexité et donc son coût.

On connaît par ailleurs le document US8436363, qui décrit un procédé de fabrication d'une structure composite comprenant une couche mince en c-SiC disposée sur un substrat support métallique dont le coefficient de dilatation thermique est apparié avec celui de la couche mince. Ce procédé de fabrication comprend les étapes suivantes :
- la formation d'un plan fragile enterré dans un substrat donneur de c-SiC, délimitant une couche mince entre ledit plan fragile enterré et une surface avant du substrat donneur,
- le dépôt d'une couche métallique, par exemple en tungstène ou en molybdène, sur la surface avant du substrat donneur pour former le substrat support d'une épaisseur suffisante pour remplir le rôle de raidisseur,
- la séparation le long du plan fragile enterré, pour former d'une part, la structure composite comprenant le substrat support métallique et la couche mince en c-SiC, et d'autre part, le reste du substrat donneur en c-SiC.

Un tel procédé de fabrication n'est cependant pas compatible lorsque le matériau formant le substrat support est du p-SiC requérant un dépôt à des températures supérieures à 1200°C (températures habituelles pour la fabrication de p-SiC). En effet, à ces températures élevées, la cinétique de croissance des cavités présentes dans le plan fragile enterré est plus rapide que la cinétique de croissance de la couche en p-SiC et l'épaisseur requise pour un effet raidisseur n'est pas atteinte avant l'apparition du phénomène de cloquage, lié à la déformation de la couche à l'aplomb des cavités.

D'autres documents de l'art antérieur décrivant différentes méthodes d'obtention de substrats composites sont DE102014103518 A1, US2018251910 A1, JP2007273524 A et FR2857982 A1.

Quelle que soit la technique de transfert de couche utilisée, se pose en outre le problème de fournir une structure composite comprenant une couche mince en c-SiC de très haute qualité, et en particulier dépourvue de défauts étendus (ou en présentant une très faible densité), susceptibles d'affecter les performances et la fiabilité des dispositifs de puissance destinés à être élaborés sur ladite couche mince.

### OBJET DE L'INVENTION

La présente invention concerne une solution alternative à celles de l'état de la technique, et vise à remédier à tout ou partie des inconvénients précités. Elle concerne en particulier un procédé de fabrication d'une structure composite comprenant une couche mince en c-SiC de haute qualité disposée sur un substrat support en SiC poly-cristallin.

### BREVE DESCRIPTION DE L'INVENTION

L'invention concerne un procédé de fabrication d'une structure composite comprenant une couche mince en carbure de silicium monocristallin disposée sur un substrat support en carbure de silicium. Le procédé comprend :
a) une étape de fourniture d'un substrat donneur en carbure de silicium monocristallin, le substrat donneur comprenant une couche donneuse réalisée par croissance épitaxiale sur un substrat initial, la couche donneuse présentant une densité de défauts cristallins inférieure à celle du substrat initial,
b) une étape d'implantation ionique d'espèces légères dans la couche donneuse, pour former un plan fragile enterré délimitant la couche mince entre ledit plan fragile enterré et une face libre de ladite couche donneuse,
c) une succession de n étapes de formation de couches supports, avec n supérieur ou égal à 2 ; les n couches supports étant disposées sur la couche donneuse successivement les unes sur les autres, et formant le substrat support ; chaque étape de formation comprenant un dépôt chimique en phase vapeur, à une température comprise entre 400°C et 1100°C, pour former une couche support en carbure de silicium poly-cristallin ; les n dépôts chimiques en phase vapeur étant opérés à n températures différentes,
d) une étape de séparation le long du plan fragile enterré, pour former d'une part une structure composite comprenant la couche mince sur le substrat support, et d'autre part le reste du substrat donneur,
e) une étape de traitement(s) mécanique(s) et/ou chimique(s) de la structure composite, pour lisser la face libre de la couche mince et/ou pour corriger l'uniformité d'épaisseur de la structure composite.

Selon d'autres caractéristiques avantageuses et non limitatives de l'invention, prises seules ou selon toute combinaison techniquement réalisable :
- les dépôts de l'étape c) sont effectués à une température comprise entre 600°C et 900°C, voire préférentiellement entre 700°C et 800°C ;
- les dépôts de l'étape c) sont basés sur une technique de dépôt en phase vapeur à pression atmosphérique, à basse pression ou assisté plasma ;
- les n dépôts de l'étape c) sont effectués à n températures croissantes ;
- les n dépôts de l'étape c) sont effectués à n températures décroissantes ;
- au moins deux couches supports parmi les n couches supports déposées à l'étape c) présentent des niveaux de dopage différents ;
- à l'issue des dépôts de l'étape c), le substrat support présente une épaisseur supérieure ou égale à 50 microns, à 100 microns, voire à 200 microns ;
- l'étape a) comprend la formation d'une couche monocristalline de conversion sur le substrat initial, préalablement à la croissance épitaxiale de la couche donneuse, pour convertir des défauts de type dislocation du plan basal du substrat initial en défauts de type dislocations coin traversantes ;
- à l'étape a), la croissance épitaxiale de la couche donneuse est effectuée à une température supérieure à 1200°C, préférentiellement comprise entre 1500°C et 1650°C ;
- à l'étape c), au moins une parmi les n étapes de formation des couches supports comprend un recuit opéré après le dépôt chimique en phase vapeur de l'étape, la température du recuit étant supérieure à la température de dépôt et inférieure à une température de séparation susceptible de provoquer la séparation de l'étape d) ;
- une gravure chimique, un rodage mécanique et/ou un polissage mécano-chimique est(sont) appliqué(s) à une face libre du substrat support, entre l'étape c) et l'étape d) ;
- un nouveau dépôt chimique en phase vapeur est opéré après la séparation de l'étape d), pour épaissir le substrat support ;
- l'étape e) comprend un polissage mécano-chimique simultané d'une face avant et d'une face arrière de la structure composite ;
- le procédé de fabrication comprend une étape de reconditionnement du reste du substrat donneur en vue d'une réutilisation en tant que substrat initial ou en tant que substrat donneur.

### BREVE DESCRIPTION DES FIGURES

D'autres caractéristiques et avantages de l'invention ressortiront de la description détaillée de l'invention qui va suivre en référence aux figures annexées sur lesquelles :

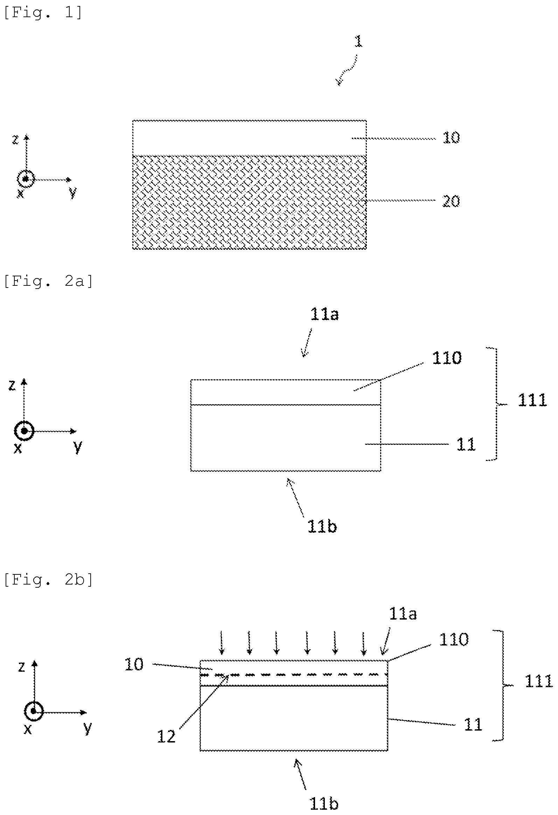

[Fig. 1] La figure 1 présente une structure composite élaborée selon un procédé de fabrication conforme à l'invention ;
[Fig. 2a]
[Fig. 2b]
[Fig. 2c(i)]

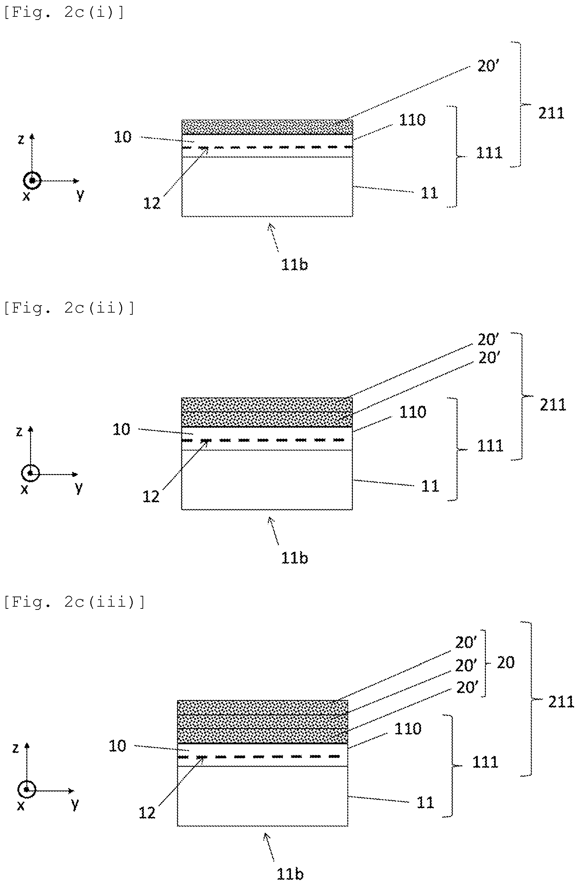

[Fig. 2c(ii)]
[Fig. 2c(iii)]
[Fig. 2d]
[Fig. 2e]

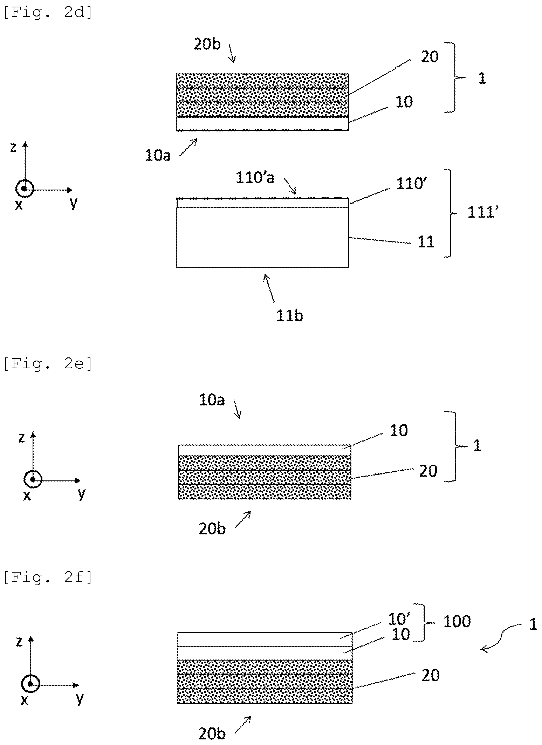

[Fig. 2f] Les figures 2a à 2f présentent des étapes d'un procédé de fabrication conforme à l'invention ;
[Fig. 3a]

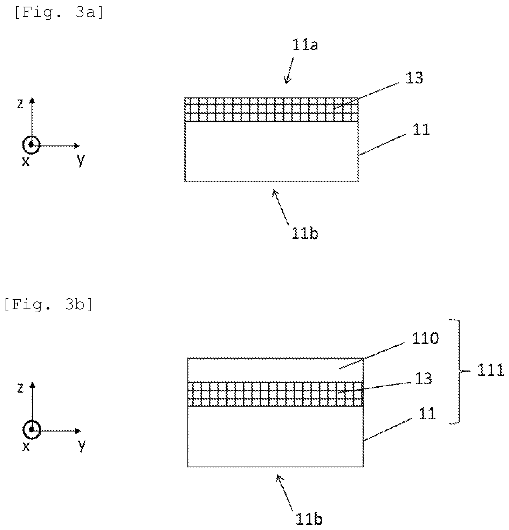

[Fig. 3b] Les figures 3a et 3b présentent des étapes d'un procédé de fabrication conforme à l'invention.

### DESCRIPTION DETAILLEE DE L'INVENTION

Dans la partie descriptive, les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

La présente invention concerne un procédé de fabrication d'une structure composite 1 comprenant une couche mince 10 en carbure de silicium monocristallin disposée sur un substrat support 20 en carbure de silicium (figure 1). Le substrat support 20 est avantageusement poly-cristallin (« p-SiC » sera utilisé par la suite pour parler de SiC poly-cristallin).

Le procédé comprend en premier lieu une étape a) de fourniture d'un substrat donneur 111 en carbure de silicium monocristallin. Dans la suite de la description, « c-SiC » sera utilisé pour parler de carbure de silicium monocristallin.

Le substrat donneur 111 comprend un substrat initial 11 en c-SiC (figure 2a). Le substrat initial 11 se présente préférentiellement sous la forme d'une plaquette de diamètre 100mm, 150mm, 200mm voire 300mm ou même 450mm, et d'épaisseur comprise typiquement entre 300 et 800 microns. Il présente une face avant 11a et une face arrière 11b. La rugosité de surface de la face avant 11a est avantageusement choisie inférieure à 1nm Ra, rugosité moyenne (« average roughness » selon la terminologie anglo-saxonne) mesurée par microscopie à force atomique (AFM) sur un scan de 20 microns x 20 microns.

Le substrat donneur 111 comprend également une couche donneuse 110 en c-SiC, réalisée par croissance épitaxiale sur le substrat initial 11. L'étape de croissance par épitaxie est effectuée de sorte que la couche donneuse 110 présente une densité de défauts cristallins inférieure à celle du substrat initial 11.

A titre d'exemple, le substrat initial 11 en c-SiC est de polytype 4H ou 6H, présentant une désorientation ("offcut") inférieure ou égale à 4.0° par rapport à l'axe cristallographique <11-20> ± 0.5°, et une densité de dislocations traversantes (« Micropipes ») inférieure ou égale à 5/cm², voire inférieure à 1/cm². Dopé de type N (azote), il présente une résistivité préférentiellement comprise entre 0.015 ohm.cm et 0.030 ohm.cm. On pourra choisir un substrat initial 11 présentant une faible densité de défauts de type dislocation du plan basal ou BPD (pour « basal plane dislocation » selon la terminologie anglo-saxonne), typiquement inférieure ou égale à 3000/cm². Des substrats de c-SiC présentant des densités de BPD de l'ordre de 1500/cm² sont raisonnablement disponibles, ce qui facilite leur approvisionnement.

Il est souhaitable que la couche donneuse 110, à partir de laquelle la couche mince 10 en c-SiC de la structure composite 1 sera formée à l'issue du procédé objet de l'invention, présente une qualité cristalline supérieure à celle du substrat initial 11, pour répondre aux spécifications requises des composants verticaux destinés à être élaborés sur ladite couche mince 10. En effet, différents types de défauts étendus sont présents dans une couche ou un substrat en c-SiC. Ces défauts étendus peuvent affecter les performances et la fiabilité des composants. En particulier, les défauts de type BPD sont tueurs pour des composants bipolaires : en effet, un défaut d'empilement de type Shockley ou SSF (pour « Shockley stacking fault ») est étendu à partir de la dislocation lorsque l'énergie de recombinaison d'une paire électron-trou est disponible. L'expansion d'un défaut d'empilement SSF à l'intérieur de la région active du composant entraîne une augmentation de la résistance à l'état passant du composant.

La couche donneuse 110 en c-SiC est donc élaborée de manière à présenter une densité de défauts de type BPD inférieure ou égale à 1/cm².

Pour cela, la croissance par épitaxie de la couche donneuse 110 est effectuée à une température supérieure à 1200°C, préférentiellement comprise entre 1500°C et 1650°C. Les précurseurs utilisés sont le silane (SiH4), le propane (C3H8) ou l'éthylène (C2H4) ; le gaz porteur pourra être de l'hydrogène avec ou sans argon.

Le faible taux de défauts BPD dans la couche donneuse 110 est obtenu en privilégiant la conversion des défauts BPD présents dans le substrat initial 11 en dislocations coins traversantes ou TED (pour « Threading Edge Dislocations »).

Selon un mode de réalisation particulier, l'étape a) comprend la formation d'une couche monocristalline de conversion 13, préférentiellement en c-SiC, sur le substrat initial 11, préalablement à la croissance de la couche donneuse 110. La couche de conversion 13 a pour but de maximiser la conversion des défauts de type BPD du substrat initial 11 en défauts de type TED (figure 3a). Pour cela, il est avantageux de choisir un angle de découpe faible proche de 4° pour le substrat initial 11 en c-SiC, d'augmenter la gravure in situ réalisée avant la croissance épitaxiale, de viser de fortes vitesses de croissance (typiquement supérieures à 5pm/h) et enfin de choisir des conditions de croissance de la couche monocristalline de conversion 13, avec un ratio C/Si au niveau des flux de précurseurs proche de 1.

La croissance épitaxiale de la couche donneuse 110 sur ladite couche de conversion 13 peut ensuite être opérée (figure 3b). Selon ce mode particulier de réalisation, il est également possible d'obtenir une couche donneuse 110 en c-SiC présentant une densité de défauts de type BPD inférieure ou égale à 1/cm² voire inférieure à 0,1/cm². De plus, la probabilité de dégradation bipolaire (probabilité qu'un trou arrive sous le point de conversion BPD/TED) à l'issue du procédé selon la présente invention est négligeable (< 0.1%), la couche monocristalline de conversion 13 n'étant pas destinée à être transférée dans la structure composite 1. L'état de l'art visant à réduire les dégradations bipolaires consiste à intégrer entre la couche de conversion et la couche active, une couche de recombinaison (dopée azote au-delà 1^{E}18 at/cm³). Cette couche peut, au prix d'une épaisseur de 10µm et d'une concentration supérieure à 5^{E}18/cm³, réduire la probabilité de présence des trous à 0,1% par rapport à la structure de base ne comportant pas cette couche de recombinaison. Dans la présente invention, la couche monocristalline de conversion 13 n'étant pas transférée, la probabilité qu'un trou atteigne le point de nucléation de la dégradation bipolaire (point de conversion BPD - TED ou tout point de BPD) est a minima inférieure à 0,1% voire proche de 0%.

Notons que des séquences conventionnelles de nettoyage ou de gravure du substrat initial 11, visant à éliminer tout ou partie de contaminants particulaires, métalliques, organiques, ou une couche d'oxyde natif potentiellement présents sur sa face avant 11a, pourront être réalisées préalablement à la croissance par épitaxie.

Le procédé de fabrication selon l'invention comprend, en outre, une étape b) d'implantation ionique d'espèces légères dans la couche donneuse 110, jusqu'à une profondeur déterminée représentative de l'épaisseur de couche mince 10 souhaitée. Notons que la profondeur restera toujours inférieure à l'épaisseur de la couche donneuse 110. Cette implantation génère un plan fragile enterré 12 dans la couche donneuse 110, qui délimite la couche mince 10 entre ledit plan fragile enterré 12 et une surface libre 11a de ladite couche donneuse 110 (figure 2b) .

Les espèces légères implantées sont préférentiellement de l'hydrogène, de l'hélium ou une co-implantation de ces deux espèces. Comme cela est bien connu en référence au procédé Smart Cut^{™}, ces espèces légères vont former, autour de la profondeur déterminée, des microcavités distribuées dans une fine couche parallèle à la surface libre 11a de la couche donneuse 110, soit parallèle au plan (x,y) sur les figures. On appelle cette fine couche le plan fragile enterré 12, par souci de simplification.

L'énergie d'implantation des espèces légères est choisie de manière à atteindre la profondeur déterminée dans le substrat donneur 111.

Typiquement, des ions hydrogène seront implantés à une énergie comprise entre 10 keV et 250 keV, et à une dose comprise entre 5^{E}16/cm2 et 1^{E}17/cm2, pour délimiter une couche mince 10 présentant une épaisseur de l'ordre de 100 à 1500 nm.

Notons qu'une couche de protection pourra être déposée sur la surface libre 11a de la couche donneuse 110, préalablement à l'étape d'implantation ionique. Cette couche de protection peut être composée par un matériau tel que l'oxyde de silicium ou le nitrure de silicium par exemple.

Le procédé selon l'invention comprend ensuite une succession de n étapes de formation de couches supports 20', avec n supérieur ou égal à 2, et avantageusement supérieur ou égal à 3. Les n couches supports 20' sont disposées sur la face libre 11a de la couche donneuse 110, successivement les unes sur les autres ; elles forment le substrat support 20. Dit autrement, une première couche support 20' est directement en contact avec la face avant 11a de la couche donneuse 110, puis une deuxième couche support 20' est en contact avec la première, et ainsi de suite pour le n couches supports 20', jusqu'à l'obtention du substrat support 20 (figure 2c(i), figure 2c(ii), figure 2c(iii)).

Chaque étape de formation comprend un dépôt chimique en phase vapeur (CVD pour « chemical vapor deposition ») pour former une couche support 20' en carbure de silicium poly-cristallin. Chaque dépôt CVD est effectué à une température comprise entre 400°C et 1100°C et préférentiellement, à une température comprise entre 600°C et 900°C, voire avantageusement entre 700°C et 800°C. Avantageusement, les dépôts de l'étape c) sont basés sur une technique de dépôt en phase vapeur à pression atmosphérique (APCVD), à basse pression (LPCVD) ou assisté plasma (PECVD).

Selon la présente invention, les n dépôts de l'étape c) sont opérés à n températures différentes. Cela permet d'améliorer la qualité du substrat support 20 issu de la superposition des n couches supports 20', comme énoncé plus loin en référence à deux modes de réalisation.

Préférentiellement, chaque couche support 20' présente une épaisseur inférieure ou égale à 150 microns, à 100 microns, voire à 50 microns.

Selon un premier mode de réalisation, les n dépôts de l'étape c) sont effectués à n températures croissantes. A titre d'exemple, quatre dépôts successifs pourront être effectués à des températures allant de 700°C à 1000°C. Notons que l'épaisseur des couches supports 20' déposées lors des dépôts successifs pourra être identique ou différente.

Ce mode de réalisation est avantageux en ce qu'il limite le budget thermique appliqué au substrat donneur 111 en début de formation des couches supports 20', c'est-à-dire lorsque l'effet raidisseur de ces couches n'est pas important : ainsi, on réduit grandement les risques d'endommagement de la couche donneuse 110 par bullage du fait de la croissance des cavités dans le plan fragile enterré 12.

De plus, même si la qualité cristalline des premières couches supports 20' déposées est moindre (du fait de la plus faible température de dépôt), les dépôts ultérieurs effectués avec des températures croissantes, permettent de guérir (au moins en partie) et/ou d'améliorer la cristallinité du ou des premier(s) dépôt(s).

Préférentiellement, la température maximale, c'est-à-dire la température appliquée lors du dernier dépôt n, est inférieure à la température susceptible d'être appliquée à l'étape d) suivante pour opérer la séparation.

Selon un deuxième mode de réalisation, les n dépôts de l'étape c) sont effectués à n températures décroissantes. A titre d'exemple, entre trois et cinq dépôts successifs pourront être effectués à des températures allant de 1000°C à 700°C.

Avantageusement, la température maximale, c'est-à-dire la température appliquée lors du premier dépôt, est inférieure à la température prévue à l'étape d) suivante pour opérer la séparation.

Ce deuxième mode de réalisation vise à former une première couche support 20' sur la couche donneuse 110 de très bonne qualité cristalline, de manière à favoriser la conductivité électrique de l'interface entre ces deux couches. La qualité des couches supports 20' suivantes sera potentiellement inférieure (compte tenu des températures de dépôt plus basses), mais les températures de dépôt décroissantes permettent de limiter la croissance des cavités dans le plan fragile enterré 12, jusqu'à atteindre l'épaisseur souhaitée du substrat support 20. On peut également considérer que des couches supports 20' déposées à des températures de plus en plus basses généreront des contraintes thermomécaniques de moins en moins importantes lors du refroidissement jusqu'à la température ambiante.

De manière optionnelle, dans l'un ou l'autre des modes de réalisation décrits, au moins une parmi les n étapes de formation des couches supports 20' comprend un recuit opéré après le dépôt chimique en phase vapeur. On choisira avantageusement une température du recuit supérieure à la température de dépôt mais inférieure à une température de séparation, susceptible d'être appliquée lors de l'étape d) ultérieure de séparation le long du plan fragile enterré 12.

En général, quel que soit le mode de réalisation adopté, le budget thermique appliqué à l'empilement 211 lors de l'une quelconque des n étapes de formation d'une couche support 20' est inférieur au budget thermique induisant une croissance des cavités dans le plan fragile enterré 12 susceptible de déformer la couche mince 10 et la (ou les) n couche(s) support(s) 20' formées au-dessus.

De plus, le budget thermique total appliqué à l'empilement 211 lors des n étapes de formation de couches supports 20' reste inférieur au budget thermique induisant une séparation spontanée le long du plan fragile enterré 12.

L'étape c) du procédé définit avantageusement une interface non-isolante entre la couche donneuse 110 et la première couche support 20' déposée lors du premier dépôt CVD. En d'autres termes, l'étape c) est réalisée de sorte que l'interface entre la couche donneuse 110 et la première couche support 20' soit apte à former une interface électriquement conductrice, au moins dans la structure composite finale 1 : on visera par exemple une résistance spécifique de l'interface typiquement inférieure à 1 mohm.cm². Avantageusement, pour assurer la conductivité électrique de l'interface, un retrait de l'oxyde natif présent sur la face libre 11a de la couche donneuse 110 est réalisé par désoxydation HF (acide fluorhydrique), par voie humide ou sèche. Préalablement à la désoxydation et/ou à la formation la première couche support 20', des séquences de nettoyage pourront être appliquées au substrat donneur 111, de manière à éliminer tout ou partie de contaminants particulaires, métalliques ou organiques potentiellement présents sur ses faces libres.

De manière avantageuse, la couche support 20' déposée lors du premier dépôt CVD présente un fort niveau de dopage, pour encore favoriser la conductivité électrique de l'interface avec le substrat donneur 111. Typiquement, la première couche support 20' déposée peut présenter une concentration en dopants de type N ou P comprise entre 1^{E}14/cm3 et 1^{E}22/cm3. Les couches supports 20' suivantes qui seront déposées, pourront présenter une concentration différente et/ou un type différent de dopants. Ainsi, au moins deux couches supports 20' parmi les n couches supports 20' déposées à l'étape c) peuvent présenter des niveaux de dopage distincts.

Les paramètres du dépôt de l'étape c) sont avantageusement déterminés pour que ledit substrat support 20 présente une bonne conductivité électrique, soit inférieure ou égale à 0,03 ohm.cm, voire à 0,01 ohm.cm, une haute conductivité thermique, soit supérieure ou égale à 150 W.m⁻¹.K⁻¹, voire à 200 W.m⁻¹.K⁻¹, et un coefficient de dilatation thermique similaire à celui de la couche mince 10, soit typiquement entre 3,8^{E}-6 /K et 4,2^{E}-6 /K à température ambiante. Pour obtenir ces propriétés, le substrat support 20 présente préférentiellement les caractéristiques structurelles suivantes : structure poly-cristalline, grains de type 3C SiC, orientés 111, de taille moyenne 1 à 50pm dans le plan du substrat, dopage de type N pour une résistivité finale inférieure ou égale à 0,03 ohm.cm.

A l'issue de l'étape c), le substrat support 20 présente une épaisseur supérieure ou égale à 10 microns, à 50 microns, à 100 microns, voire même une épaisseur supérieure ou égale à 200 microns. L'empilement 211 résultant de l'étape c) comprend le substrat support 20 disposé sur le substrat donneur 111.

Le procédé selon la présente invention comprend ensuite une étape d) de séparation le long du plan fragile enterré 12, pour former d'une part la structure composite 1 et d'autre part le reste 111' du substrat donneur (figure 2d).

Selon un mode avantageux de mise en oeuvre, l'étape d) de séparation est opérée en appliquant un traitement thermique à l'empilement 211, à une température de séparation supérieure aux températures de dépôts et de recuit(s) (si opéré(s)) de l'étape c). En effet, les microcavités présentes dans le plan fragile enterré 12 suivent une cinétique de croissance jusqu'à l'initiation d'une onde de fracture qui va se propager sur toute l'étendue du plan fragile enterré 12 et provoquer la séparation entre la structure composite 1, et le reste du substrat initial 111'. En pratique, la température pourra être comprise entre 950°C et 1200°C, et préférentiellement entre 1000°C et 1200°C, en fonction des conditions d'implantation de l'étape b).

Selon un mode alternatif de mise en oeuvre, l'étape d) de séparation est opérée par application d'une contrainte mécanique à l'empilement 211. La contrainte pourra par exemple être exercée par l'insertion d'un outil (par exemple, une lame ou une forme en biseau) à proximité du plan fragile enterré 12. A titre d'exemple, la contrainte de séparation pourra être de l'ordre de quelques GPa, préférentiellement supérieure à 2GPa.

Notons que l'on peut éventuellement prévoir de réaliser, après la séparation de l'étape d), au moins un nouveau dépôt CVD pour épaissir davantage le substrat support 20.

Après l'étape d), on obtient une structure composite 1 comprenant une couche mince 10 en carbure de silicium monocristallin disposée sur un substrat support 20 en carbure de silicium poly-cristallin.

Comme cela est connu en soi, à l'issue de l'étape d) de séparation, la face libre 10a de la couche mince 10 de la structure composite 1 présente une rugosité de surface comprise entre 5 et 100 nm RMS (par mesure au microscope à force atomique (AFM), sur des scans de 20 microns x 20 microns).

Une étape e) de traitement(s) mécanique(s) et/ou chimique(s) de la structure composite 1 est donc prévue pour lisser la surface libre 10a de la couche mince 10 et/ou pour corriger l'uniformité d'épaisseur de ladite structure 1 (figure 2e).

L'étape e) peut comprendre un polissage mécano-chimique (CMP) de la face libre 10a de la couche mince 10, typiquement avec un retrait de matière de l'ordre de 50 nm à 1000 nm, de manière à obtenir une rugosité finale inférieure à 0,5 nm Rms (sur un champ AFM de 20x20pm), voire inférieure à 0,3 nm. L'étape e) peut également comprendre un traitement chimique ou plasma (nettoyage ou gravure), par exemple un nettoyage de type SC1/SC2 (Standard Clean 1, Standard Clean 2) et/ou HF (acide fluorhydrique), ou un plasma N2, Ar, CF4, etc, pour améliorer encore la qualité de la face libre 10a de la couche mince 10.

De plus, l'étape e) peut comprendre un polissage mécano-chimique (CMP) et/ou un traitement chimique (gravure ou nettoyage) et/ou un traitement mécanique (rectification) de la face arrière 20b du substrat support 20. Un tel traitement permet d'améliorer l'uniformité d'épaisseur dudit substrat support 20 ainsi que sa rugosité en face arrière 20b. Une rugosité inférieure à 0,5 nm RMS (par mesure au microscope à force atomique (AFM), sur des champs de 20 microns x 20 microns) est souhaitée pour élaborer des composants verticaux, pour lesquels au moins une électrode métallique sera présente sur la face arrière 20b du substrat composite 1.

Notons que ces traitements appliqués à la face arrière 20b du substrat support 20 pourraient optionnellement être opérés juste avant l'étape d) de séparation, c'est-à-dire avant que la face avant 10a de la structure composite 1 ne soit mise à nu, de manière à limiter sa contamination, notamment au cours de traitements polluants ou contraignants tels que la gravure chimique ou le rodage mécanique (ou rectification mécanique).

On pourra également réaliser, lors de cette étape e), un polissage ou une rectification des bords de la structure composite 1 pour rendre compatible la forme de son contour circulaire et de la tombée de bord avec les exigences des procédés de fabrication microélectronique.

Selon un mode de réalisation avantageux, l'étape e) de traitement mécano-chimique comprend un polissage (CMP) simultané d'une face avant 10a et d'une face arrière 20b de la structure composite 1, pour lisser et améliorer l'uniformité d'épaisseur de ladite structure 1. Les paramètres de polissage pourront être différents entre la face avant 10a et la face arrière 20b, le lissage d'une surface de c-SiC et d'une surface de p-SiC requérant habituellement des consommables différents. On privilégie en particulier la composante mécanique du polissage pour la face arrière 20b lorsque le substrat support 20 est en p-SiC, pour limiter l'attaque préférentielle des joints de grains par la composante chimique du polissage. Au titre d'exemple, les paramètres de polissage, comme la vitesse de rotation (tête de polissage et plateau), la pression, la concentration et les propriétés physiques des abrasifs (i.e. diamètre de nanoparticules de diamant entre une dizaine de nm et 1µm), peuvent être modifiés pour accentuer la composante mécanique.

Toujours selon un mode de réalisation avantageux, une étape e') de traitement thermique à une température comprise entre 1000°C et 1800°C, pendant environ une heure et jusqu'à quelques heures, est opérée après l'étape e). L'objectif de cette étape est de stabiliser la structure composite 1, en guérissant des défauts structurels ou de surface, encore présents dans et/ou sur la couche mince 10, et en faisant, le cas échéant, évoluer la configuration cristalline du substrat support 20, de sorte que la structure 1 soit compatible avec des traitements thermiques ultérieurs à hautes températures, requis pour la fabrication de composants sur la couche mince 10.

Le procédé selon l'invention peut comprendre une étape f) de croissance par épitaxie d'une couche additionnelle 10' de carbure de silicium monocristallin sur la couche mince 10 de la structure composite 1 (figure 2f). Une telle étape est appliquée lorsqu'une épaisseur relativement importante de couche utile 100 est nécessaire pour la fabrication de composants, typiquement, de l'ordre de 5 à 50 microns. Les conditions d'épitaxie peuvent éventuellement être choisies similaires à celles de l'étape a), préférentiellement à plus basse température de manière à limiter les contraintes induites dans la couche utile 100 (correspondant à l'ensemble couche mince 10 et couche additionnelle 10') du fait des matériaux hétérogènes de la structure composite 1.

Enfin, le procédé de fabrication peut comprendre une étape de reconditionnement du reste 111' du substrat donneur en vue d'une réutilisation en tant que substrat initial 11 ou en tant que substrat donneur 111. Une telle étape de reconditionnement est basée sur un ou plusieurs traitements de la face 110'a (figure 2d), par polissage mécano-chimique de surface ou de bords, et/ou par rectification mécanique, et/ou par gravure chimique sèche ou humide. Préférentiellement, l'épaisseur de la couche donneuse 110 formée à l'étape a) est définie de sorte que le reste 111' du substrat donneur 111 puisse être réutilisé au moins deux fois en tant que substrat donneur 111. Préférentiellement, lorsque la couche de conversion 13 est présente, on prendra garde à conserver ladite couche intacte, c'est-à-dire à conserver toujours une part de couche donneuse 10 sur le reste 111' du substrat donneur. Ainsi, lorsque la part de couche donneuse 10 est insuffisante pour l'élaboration d'une structure composite 1, seule l'étape de croissance par épitaxie de couche donneuse 10 est nécessaire et non l'étape préalable de croissance de la couche de conversion 13.

### Exemple :

Selon un exemple non limitatif de mise en oeuvre, le substrat initial 11 est une plaquette de c-SiC, de polytype 4H, d'orientation 4.0° par rapport à l'axe <11-20> ± 0.5°, de diamètre 150mm et d'épaisseur 350pm.

Une séquence classique de nettoyage de type RCA (Standard Clean 1 + Standard Clean 2), puis Caro (mélange d'acide sulfurique et d'eau oxygénée), puis HF (acide fluorhydrique), est opérée sur le substrat initial 11 préalablement à la croissance épitaxiale de la couche donneuse 110 en c-SiC.

La croissance est réalisée dans une chambre d'épitaxie, à une température de 1650°C, avec des précurseurs tels que le silane (SiH4) et le propane (C3H8) ou l'éthylène (C2H4), générant la couche donneuse 110 en c-SiC de 30 microns d'épaisseur (vitesse de croissance : 10 microns/h). La couche donneuse présente une densité de défauts BPD de l'ordre de 1/cm².

L'implantation d'ions hydrogène est opérée à une énergie de 150 keV et une dose de 6^{E}16 H+/cm², à travers la surface libre de la couche donneuse 110. Un plan fragile enterré 12 est ainsi créé à une profondeur d'environ 800 nm dans la couche donneuse 110. Une séquence de nettoyage de type RCA + Caro est opérée sur le substrat donneur 111, de manière à éliminer les potentielles contaminations sur la face libre de la couche donneuse 110.

Un premier dépôt LPCVD est effectué sur la couche donneuse 110, à une température de 700°C, avec le précurseur methylsilane (MS) (CH3SiH3), sous une pression de 3,7 Torr, pendant 60 minutes, de manière à atteindre une épaisseur de 50 microns pour la première couche support 20'. Dans ces conditions, ladite couche support 20' est en SiC poly-cristalline.

Un deuxième dépôt LPCVD est effectué sur la première couche support 20', à une température de 800°C, avec le précurseur MS, sous une pression de 4 Torr, pendant 30 minutes, de manière à atteindre une épaisseur de 100 microns pour la deuxième couche support 20' en p-SiC.

Un troisième dépôt LPCVD est effectué sur la deuxième couche support 20', à une température de 850°C, avec le précurseur MS, sous une pression de 4 Torr, pendant 45 minutes, de manière à atteindre une épaisseur de 250 microns pour la troisième couche support 20' en p-SiC.

Le substrat support 20 formé par la superposition des trois couches supports 20' présente une épaisseur de 400 microns.

Un recuit à 1000°C pendant 50 min est ensuite appliqué à l'empilement 211 formé du substrat donneur 111 et du substrat support 20. La séparation s'opère au niveau du plan fragile enterré 12 au cours dudit recuit. A l'issue de cette étape d) de séparation, la structure composite 1 formée de la couche mince 10 et du substrat support 20 est séparée du reste 111' du substrat donneur.

Une épaisseur de l'ordre de 50 microns est retirée au niveau de la face arrière 20b du substrat support 20. Puis un polissage double face est opéré pour restaurer la rugosité de surface de la couche mince 10 et de la face arrière 20b du substrat support 20.

Bien entendu, l'invention n'est pas limitée aux modes de réalisation et aux exemples décrits, et on peut y apporter des variantes de réalisation sans sortir du cadre de l'invention tel que défini par les revendications.

## Revendications

1. Procédé de fabrication d'une structure composite (1) comprenant une couche mince (10) en carbure de silicium monocristallin disposée sur un substrat support (20) en carbure de silicium, le procédé comprenant:
**a)** une étape de fourniture d'un substrat donneur (111) en carbure de silicium monocristallin, le substrat donneur (111) comprenant une couche donneuse (110) réalisée par croissance épitaxiale sur un substrat initial (11), la couche donneuse (110) présentant une densité de défauts cristallins inférieure à celle du substrat initial (11),
**b)** une étape d'implantation ionique d'espèces légères dans la couche donneuse (110), pour former un plan fragile enterré (12) délimitant la couche mince (10) entre ledit plan fragile enterré (12) et une face libre de ladite couche donneuse (110),
**c)** une succession de n étapes de formation de couches supports (20'), avec n supérieur ou égal à 2 ; les n couches supports (20') étant disposées sur la couche donneuse (110) successivement les unes sur les autres, et formant le substrat support (20) ; chaque étape de formation comprenant un dépôt chimique en phase vapeur, à une température comprise entre 400°C et 1100°C, pour former une couche support (20') en carbure de silicium poly-cristallin ; les n dépôts chimiques en phase vapeur étant opérés à n températures différentes,
**d)** une étape de séparation le long du plan fragile enterré (12), pour former d'une part une structure composite (1) comprenant la couche mince (10) sur le substrat support (20), et d'autre part le reste (111') du substrat donneur,
**e)** une étape de traitement(s) mécanique(s) et/ou chimique(s) de la structure composite (1), pour lisser la face libre (10a) de la couche mince (10) et/ou pour corriger l'uniformité d'épaisseur de la structure composite (1).

2. Procédé de fabrication selon la revendication précédente, dans lequel les dépôts de l'étape c) sont effectués à une température comprise entre 600°C et 900°C, voire préférentiellement entre 700°C et 800°C.

3. Procédé de fabrication selon l'une des revendications précédentes, dans lequel les dépôts de l'étape c) sont basés sur une technique de dépôt en phase vapeur à pression atmosphérique, à basse pression ou assisté plasma.

4. Procédé de fabrication selon l'une des revendications précédentes, dans lequel les n dépôts de l'étape c) sont effectués à n températures croissantes.

5. Procédé de fabrication selon l'une des revendications 1 à 3, dans lequel les n dépôts de l'étape c) sont effectués à n températures décroissantes.

6. Procédé de fabrication selon l'une des revendications précédentes, dans lequel au moins deux couches supports (20') parmi les n couches supports (20') déposées à l'étape c) présentent des niveaux de dopage différents.

7. Procédé de fabrication selon l'une des revendications précédentes, dans lequel, à l'issue des dépôts de l'étape c), le substrat support (20) présente une épaisseur supérieure ou égale à 50 microns, à 100 microns, voire à 200 microns.

8. Procédé de fabrication selon l'une des revendications précédentes, dans lequel l'étape a) comprend la formation d'une couche monocristalline de conversion (13) sur le substrat initial (11), préalablement à la croissance épitaxiale de la couche donneuse (110), pour convertir des défauts de type dislocation du plan basal du substrat initial (11) en défauts de type dislocations coin traversantes.

9. Procédé de fabrication selon l'une des revendications précédentes, dans lequel, à l'étape a), la croissance épitaxiale de la couche donneuse (110) est effectuée à une température supérieure à 1200°C, préférentiellement comprise entre 1500°C et 1650°C.

10. Procédé de fabrication selon l'une des revendications précédentes, dans lequel à l'étape c), au moins une parmi les n étapes de formation des couches supports (20') comprend un recuit opéré après le dépôt chimique en phase vapeur de l'étape, la température du recuit étant supérieure à la température de dépôt et inférieure à une température de séparation susceptible de provoquer la séparation de l'étape d).

11. Procédé de fabrication selon l'une des revendications précédentes, dans lequel une gravure chimique, un rodage mécanique et/ou un polissage mécano-chimique est(sont) appliqué(s) à une face arrière (20b) du substrat support (20), entre l'étape c) et l'étape d).

12. Procédé de fabrication selon l'une des revendications précédentes, dans lequel un nouveau dépôt chimique en phase vapeur est opéré après la séparation de l'étape d), pour épaissir le substrat support (20).

13. Procédé de fabrication selon l'une des revendications précédentes, dans lequel l'étape e) comprend un polissage mécano-chimique simultané d'une face avant (10a) et d'une face arrière (20b) de la structure composite (1).

14. Procédé de fabrication selon l'une des revendications précédentes, comprenant une étape de reconditionnement du reste (111') du substrat donneur en vue d'une réutilisation en tant que substrat initial (11) ou en tant que substrat donneur (111).

## Patentansprüche

1. Verfahren zum Herstellen einer Verbundstruktur (1), umfassend eine dünne Schicht (10) aus monokristallinem Siliciumcarbid, die auf einem Trägersubstrat (20) aus Siliciumcarbid angeordnet ist, das Verfahren umfassend:
**a)** einen Schritt eines Bereitstellens einer Donorsubstrats (111) aus monokristallinem Siliciumcarbid, das Donorsubstrat (111) umfassend eine Donorschicht (110), die durch epitaktisches Wachstum auf einem Anfangssubstrat (11) erfolgt, wobei die Donorschicht (110) eine Dichte an kristallinen Defekten aufweist, die kleiner als die des Anfangssubstrats (11) ist,
**b)** einen Schritt eines lonenimplantierens von leichten Spezies in die Donorschicht (110) zum Ausbilden einer spröden eingegrabenen Ebene (12), die die dünne Schicht (10) zwischen der spröden eingegrabenen Schicht (12) und einer freien Fläche der Donorschicht (110) begrenzt,
**c)** eine Folge von n Schritten eines Ausbildens von Trägerschichten (20') mit n kleiner als oder gleich 2; wobei die n Trägerschichten (20') auf der Donorschicht (110) aufeinanderfolgend übereinander angeordnet sind und das Trägersubstrat (20) ausbilden; jeder Ausbildungsschritt umfassend eine chemische Gasphasenabscheidung bei einer Temperatur zwischen 400 °C und 1100 °C zum Ausbilden einer Trägerschicht (20') aus polykristallinem Siliciumcarbid; wobei die n chemischen Gasphasenabscheidungen bei n unterschiedlichen Temperaturen ausgeführt werden,
**d)** einen Schritt eines Trennens entlang der spröden eingegrabenen Ebene (12) zum Ausbilden einerseits einer Verbundstruktur (1), umfassend die dünne Schicht (10), auf dem Trägersubstrat (20), und andererseits des Rests (111') des Donorsubstrats,
**e)** einen Schritt einer/von mechanischen und/oder chemischen Bearbeitung(en) der Verbundstruktur (1) zum Glätten der freien Fläche (10a) der dünnen Schicht (10) und/oder zum Korrigieren der Dickengleichmäßigkeit der Verbundstruktur (1).

2. Herstellungsverfahren nach dem vorstehenden Anspruch, wobei die Abscheidungen von Schritt c) bei einer Temperatur zwischen 600 °C und 900 °C, sogar vorteilhafterweise zwischen 700 °C und 800 °C, vorgenommen werden.

3. Herstellungsverfahren nach einem der vorstehenden Ansprüche, wobei die Abscheidungen von Schritt c) auf einer Gasphasenabscheidungstechnik bei Atmosphärendruck, bei Niederdruck oder mit Plasmaunterstützung basieren.

4. Herstellungsverfahren nach einem der vorstehenden Ansprüche, wobei die n Abscheidungen von Schritt (c) bei n steigenden Temperaturen vorgenommen werden.

5. Herstellungsverfahren nach einem der Ansprüche 1 bis 3, wobei die n Abscheidungen von Schritt (c) bei n sinkenden Temperaturen vorgenommen werden.

6. Herstellungsverfahren nach einem der vorstehenden Ansprüche, wobei die mindestens zwei Trägerschichten (20') unter den n Trägerschichten (20'), die in Schritt c) abgeschieden werden, unterschiedliche Dotierungspegel aufweisen.

7. Herstellungsverfahren nach einem der vorstehenden Ansprüche, wobei das Trägersubstrat (20) nach den Abscheidungen von Schritt c) eine Dicke von größer als oder gleich 50 Mikrometer, 100 Mikrometer, sogar 200 Mikrometer, aufweist.

8. Herstellungsverfahren nach einem der vorstehenden Ansprüche, wobei der Schritt a) das Ausbilden einer monokristallinen Umwandlungsschicht (13) auf dem Anfangssubstrat (11), vor dem epitaktischen Wachstum der Donorschicht (110), zum Umwandeln von Defekten einer Art einer Versetzung der Basalebene des Anfangssubstrats (11) in Defekte einer Art von durchgehenden Randversetzungen umfasst.

9. Herstellungsverfahren nach einem der vorstehenden Ansprüche, wobei in Schritt a) das epitaktische Wachstum der Donorschicht (110) bei einer Temperatur über 1200 °C, vorzugsweise zwischen 1500 °C und 1650 °C, vorgenommen wird.

10. Herstellungsverfahren nach einem der vorstehenden Ansprüche, wobei in Schritt c) mindestens einer unter den n Schritten zum Ausbilden von Trägerschichten (20') ein Tempern umfasst, das nach der chemischen Gasphasenabscheidung ausgeführt wird, wobei die Temperatur des Temperns größer als die Temperatur des Abscheidens und kleiner als eine Temperatur des Trennens ist, die geeignet ist, das Trennen von Schritt d) zu bewirken.

11. Herstellungsverfahren nach einem der vorstehenden Ansprüche, wobei ein chemisches Ätzen, ein mechanisches Läppen und/oder ein mechanisch-chemisches Polieren auf eine Rückfläche (20b) des Trägersubstrats (20) zwischen Schritt c) und Schritt d) angewendet wird/werden.

12. Herstellungsverfahren nach einem der vorstehenden Ansprüche, wobei eine neue chemische Gasphasenabscheidung nach dem Trennen von Schritt d) zum Verdicken des Trägersubstrats (20) ausgeführt wird.

13. Herstellungsverfahren nach einem der vorstehenden Ansprüche, wobei Schritt e) ein gleichzeitiges mechanisch-chemisches Polieren einer Vorderfläche (10a) und einer Rückfläche (20b) der Verbundstruktur (1) umfasst.

14. Herstellungsverfahren nach einem der vorstehenden Ansprüche, umfassend einen Schritt eines Wiederaufbereitens des Rests (111') des Donorsubstrats im Hinblick auf eine Wiederverwendung in der Eigenschaft als Anfangssubstrat (11) oder in der Eigenschaft als Donorsubstrat (111).

## Claims

1. Method for producing a composite structure (1) comprising a thin layer (10) which is made of monocrystalline silicon carbide and arranged on a support substrate (20) made of silicon carbide, the method comprising:
**a)** a step of providing a donor substrate (111) made of monocrystalline silicon carbide, the donor substrate (111) comprising a donor layer (110) created by epitaxial growth on an initial substrate (11), the donor layer (110) having a density of crystalline defects of less than that of the initial substrate (11),
**b)** a step of implanting ions of light species into the donor layer (110) to form a buried brittle plane (12) which delimits the thin layer (10) between the buried brittle plane (12) and a free face of the donor layer (110),
**c)** a succession of n steps of forming support layers (20'), with n being greater than or equal to 2; the n support layers (20') being arranged on the donor layer (110) successively one on top of the other, and forming the support substrate (20); each formation step comprising chemical vapor deposition, at a temperature between 400°C and 1100°C, to form a support layer (20') made of polycrystalline silicon carbide; the n chemical vapor depositions being carried out at n different temperatures,
**d)** a step of separating along the buried brittle plane (12) to form a composite structure (1) which comprises the thin layer (10) on the support substrate (20) on one side and the remainder (111') of the donor substrate on the other,
**e)** a step of mechanical and/or chemical treatment(s) of the composite structure (1) to smooth the free face (10a) of the thin layer (10) and/or to correct the uniformity of thickness of the composite structure (1).

2. Production method according to the preceding claim, wherein the depositions of step c) are carried out at a temperature of between 600°C and 900°C, or preferably between 700°C and 800°C.

3. Production method according to either of the preceding claims, wherein the depositions of step c) are based on a vapor deposition technique at atmospheric pressure, at low pressure, or which is plasma-assisted.

4. Production method according to any of the preceding claims, wherein the n depositions of step c) are carried out at n increasing temperatures.

5. Production method according to any of claims 1 to 3, wherein the n depositions of step c) are carried out at n decreasing temperatures.

6. Production method according to any of the preceding claims, wherein at least two support layers (20') from among the n support layers (20') deposited in step c) have different doping levels.

7. Production method according to any of the preceding claims, wherein, at the end of the depositions of step c), the support substrate (20) has a thickness greater than or equal to 50 microns, or greater than or equal to 100 microns, or greater than or equal to 200 microns.

8. Production method according to any of the preceding claims, wherein step a) comprises forming, on the initial substrate (11), prior to the epitaxial growth of the donor layer (110), a monocrystalline conversion layer (13) to convert dislocation defects of the basal plane of the initial substrate (11) into through-corner dislocation defects.

9. Production method according to any of the preceding claims, wherein, in step a), the epitaxial growth of the donor layer (110) is carried out at a temperature of greater than 1200°C, preferably between 1500°C and 1650°C.

10. Production method according to any of the preceding claims, wherein, in step c), at least one among the n steps of forming the support layers (20') comprises annealing carried out after the chemical vapor deposition of the step, the annealing temperature being greater than the deposition temperature and less than a separation temperature capable of causing the separation of step d).

11. Production method according to any of the preceding claims, wherein chemical etching, mechanical grinding and/or chemical-mechanical polishing is/are applied to a rear face (20b) of the support substrate (20) between step c) and step d).

12. Production method according to any of the preceding claims, wherein a new chemical vapor deposition is carried out after the separation of step d), to thicken the support substrate (20).

13. Production method according to any of the preceding claims, wherein step e) comprises simultaneous chemical-mechanical polishing of a front face (10a) and a rear face (20b) of the composite structure (1).

14. Production method according to any of the preceding claims, comprising a step of reconditioning the remainder (111') of the donor substrate for reuse as an initial substrate (11) or as a donor substrate (111).
